# EUROPEAN PATENT APPLICATION

(11) **EP 4 661 300 A1**
(43) Date of publication of application: **10.12.2025**
(21) Application number: 25180973.7
(22) Date of filing: 05.06.2025
(51) Int. Cl.: H04B 1/04, H03F 1/02, H03F 3/68

(54) **SIGNAL COMBINERS AND ASSOCIATED COMMUNICATION PROTOCOL**

(30) Priority: 06.06.2024 US 202418735994
(71) Applicant: Shure Acquisition Holdings, Inc., Niles, IL 60714 (US)
(72) Inventor: HALVERSON, Jon, Niles, 60714 (US); JOZWIAK, Bryan Lee, Niles, 60714 (US); VAN GHEEM, Steven John, Niles, 60714 (US); LEVINSKY, Aaron, Niles, 60714 (US); BRUMM, Scott N, Niles, 60714 (US); SMITH, Tristan, Niles, 60714 (US); GU, Junjie, Niles, 60714 (US); CHARANIA, Haneef B., Niles, 60714 (US); CHEN, Jier, Niles, 60714 (US); GOODSON, Michael J., Niles, 60714 (US)
(74) Representative: Bryers Intellectual Property Ltd

(57) **Abstract**

Aspects of the disclosure relate to use of signal combiners for multiplexing signals. A transmitter may adjust a transmission power of an output signal to compensate for transmission losses associated with the use of signal combiners. The adjustment may be based on a combining mode as indicated by a combiner. The combiner may indicate a combining mode as a voltage level at an output port of the transmitter. If operating in a cascaded mode, the combiner may determine and indicate a cumulative combining mode based on an operating mode/type of the combiner and an operating mode/type as indicated by a downstream combiner.

## Description

### TECHNICAL FIELD

Aspects of the disclosure relate to electronic communication and more specifically to networks utilizing signal combiners for multiplexing transmitters.

### BACKGROUND

Signal combiners may be used to multiplex signals, from multiple transmitters, prior to transmission. For example, multiple transmitters may share a same antenna module. A combining network, comprising one or more combiners, may multiplex transmissions from the multiple transmitters to generate a single combined signal. The combined signal may be transmitted via the antenna module.

### SUMMARY

Aspects of the disclosure provide effective, scalable, and reliable technical solutions that address and overcome the problems associated with interfacing multiple communication devices for communication via a same module. More specifically, the solutions described herein facilitate adjustment of transmission parameters (e.g., a transmission power) based on a configuration of a combiner network.

An example communication system may comprise one or more transmitters interfaced with one or more combiners. The combiners may be used to multiplex signals (e.g., radio frequency (RF) signals) from the transmitters prior to transmission. A combiner may indicate, via an input port of the combiner, a cumulative combining mode to an upstream device (e.g., another combiner, or a transmitter). The cumulative combining mode may be based on a received indication, from a downstream combiner, of a downstream combining mode and may be based on a combining mode of the combiner. A transmitter may receive, via an output port, an indication of the cumulative combining mode. Based on the cumulative combining mode, the transmitter may adjust an output power of an RF signal via the output port. These features, along with many others, are discussed in greater detail below.

### BRIEF DESCRIPTION OF THE DRAWINGS

The present disclosure is illustrated by way of example and not limited in the accompanying figures in which like reference numerals indicate similar elements and in which:
FIG. 1A shows an example architecture of a system employing signal combination.
FIG. 1B shows an example communication between transmitter(s) and combiner(s).
FIG. 2 shows an example configuration of output ports in a transmitter.
FIG. 3 shows an example combiner.
FIG. 4 shows an example combiner.
FIGS. 5A-5C show example systems comprising multiple transmitters.
FIG. 6 shows an example method of operation of a combiner.
FIG. 7 shows an example method for detection and processing of an indication of a cumulative combining mode.
FIG. 8 shows an example state diagram of a device that is connected to a downstream combiner.
FIGS. 9A and 9B shows example indications of a cumulative combining mode to an upstream device.
FIG. 10 shows an example system in accordance with one or more examples as described herein.

### DETAILED DESCRIPTION

**In** the following description of various illustrative embodiments, reference is made to the accompanying drawings, which form a part hereof, and in which is shown, by way of illustration, various embodiments in which aspects of the disclosure may be practiced. It is to be understood that other embodiments may be utilized, and structural and functional modifications may be made, without departing from the scope of the present disclosure. It is noted that various connections between elements are discussed in the following description. It is noted that these connections are general and, unless specified otherwise, may be direct or indirect, wired or wireless, and that the specification is not intended to be limiting in this respect.

One or more combiners may be used to combine signals from multiple sources (e.g., transmitters) to generate a single signal for further processing and/or further transmission (e.g., wired and/or wireless transmission). For example, a combiner may generate, from a plurality of input signals (e.g., input via a plurality of input ports of the combiner), a single output signal (e.g., output via an output port of the combiner) that is based on a combination of the plurality of input signals. The signals may be radio frequency (RF) signals comprising analog and/or digital information. The signals may comprise audio data and/or any other type of information.

The use of a combiner network, to generate a combined signal, may cause transmission losses. As such, a transmission power of a signal, as sent by a transmitter, may be diminished following the combining process. To account for losses in the combiner network, combiners may comprise or may be interfaced with signal amplifiers. For example, the signal amplifiers may increase a power of a signal, as received from a transmitter, prior to further transmission. However, the use of such combiners/amplifiers may increase the cost and complexity of the system.

Another way to compensate for losses in the combiner network may be to increase a signal strength (e.g., by increasing a transmission power) of a signal, at a transmitter, prior to inputting the signal to the combiner network. In such an embodiment, the combiner network need not include an amplification function, and may purely perform signal combination prior to further transmission. However, arbitrarily using a high transmission power, at a transmitter, may result in a total transmitted power (e.g., as radiated by an antenna) exceeding regulatory limits. For example, multiple transmitters and combiners may be flexibly set up in different configurations (e.g., with different numbers of transmitters and combiners), with each configuration being associated with a corresponding transmission loss. Transmission losses may be based on (e.g., may be proportional to) a total number of transmitters/signals that are supported by the combiner network. Using a same preconfigured high transmission power, from the transmitters, for all configurations may result in radiated power exceeding regulatory limits for at least some configurations. Additionally or alternatively, using a preconfigured high transmission power may be inefficient. To ensure that the total transmitted power is within regulatory limits and remains efficient, instead of using an arbitrary transmission power, a transmitter may need to determine a configuration of the network and accordingly adjust its output power.

Various examples herein describe methods, devices, and systems that enable flexible adjustment of a transmission power, from a signal transmitter, based on a configuration of a combiner network. A signaling protocol, as described herein, may enable a transmitter to determine a configuration of the combiner network. For example, the transmitter may be able to determine a connection status, a total quantity of transmitters that are supported by/connected to the combiner network, a total quantity of channels/output ports (e.g., of the transmitters) that are supported by/connected to the combiner network, and/or the type(s) of combiner(s) used in the combiner network. The transmitter may adjust an output power, of a transmitted signal, based on the determination. Flexible adjustment of transmission power, as described herein, may result in improved power efficiency and/or better compliance with regulatory requirements.

Each combiner, in a combiner network, may indicate a corresponding cumulative (e.g., total) combining mode to an upstream combiner and/or a transmitter. The cumulative combining mode, as indicated by a combiner, may be based on a combining mode of the combiner and, if another combiner is present downstream from the combiner, a corresponding cumulative combining mode as indicated by the other combiner. The cumulative combining mode, as indicated by the combiner, may be based on a type of downstream combiner(s) and/or a type of the combiner. The combining mode of the combiner may correspond to/be based on a total quantity of channels supported by the combiner (e.g., a total quantity of input signals being combined by the combiner).

Signaling for indicating a combining mode, as described herein, may be via the same cables/conductors that are used for transmission of RF signals from a set of transmitters (e.g., to a transmitting antenna). Using the same wiring for signal transmission and indication of a combining mode may simplify the system setup.

A transmitter may determine, based on a received indication of a cumulative combining mode, a connection status of the combiner network, a total quantity of transmitters that are supported by/connected to the combiner network, a total quantity of channels/output ports (e.g., of the transmitters) that are supported by/connected to the combiner network, and/or the type(s) of combiner(s) used in the combiner network

As used herein, an active combiner generally refers to a combiner that is capable of indicating a (cumulative) combining mode by transmitting a signal (e.g., a pulse wave) to an upstream device, and a passive combiner generally refers to a combiner that indicates a combining mode as a voltage drop across a load resistor (e.g., associated with an input port of the passive combiner). Further, as used herein, a combiner (e.g., an active combiner or a passive combiner) may (or may not) be capable of performing signal amplification prior to further signal transmission (e.g., to a downstream combiner and/or an antenna).

The use of a signaling protocol as described herein may also enable a user to determine a cumulative combining mode facilitated by a combiner network. For example, a user device (e.g., a computing device, such as a laptop, a smartphone, or an audio device) may be configured to receive an indicated cumulative combining mode (e.g., from one or more downstream combiners). A user may review the cumulative combining mode to determine whether the transmitters and the combiner network have been configured and/or wired correctly. Further, the signaling protocol may also be used for transmitting/indicating information other than a cumulative combining mode.

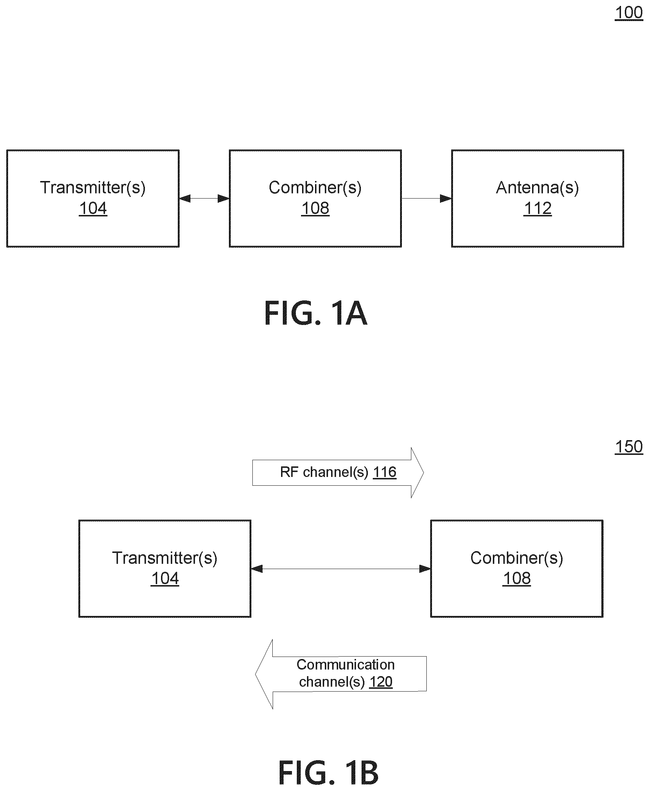

FIG. 1A shows an example architecture of a system 100 employing signal combination. The system 100 may comprise one or more transmitter(s) 104 in communication with and/or connected to one or more combiner(s) 108. Each of the one or more transmitter(s) 104 may comprise one or more output ports, with each output port being used for transmission of a corresponding RF signal. The RF signals may correspond to information as received from upstream transducers/other devices (e.g., microphones, audio input devices/ports, memory devices, signal processing devices, etc.) connected to the transmitter(s) 104 and/or information as generated by the transmitter(s) 104.

The combiner(s) 108 may be used to multiplex RF signals as received from the output ports of the transmitter(s) 104. For example, the combiner(s) 108 may be arranged in the form of one or more layers to generate a single multiplexed output signal based on the RF signals from the output ports of the transmitter(s) 104. The output signal may be sent/transmitted via one or more antennas 112.

The system 100 may be configured for unidirectional and/or bidirectional communication. For example, in at least some embodiments, the system 100 may comprise receiver modules that may receive signals (e.g., RF signals) from other devices in the network (e.g., via the antennas 112 and/or via a different set of antennas). For example, the system 100 may be associated with and/or comprise receiver modules for receiving and processing wired or wireless transmissions.

While the example system 100 shows the combiner(s) 108 generating an output signal for transmission via the antenna(s) 112, in other examples, the output signal as generated by the combiner(s) 108 may be transmitted via a wired communication channel. In other words, the transmitter-combiner architecture of the system 100 may be used for wireless or wired signal transmission.

FIG. 1B shows an example communication 150 between the transmitter(s) 104 and the combiner(s) 108. The transmitter(s) 104 may send RF signals (e.g., via output ports) to the combiner(s) 108. The RF signals may be sent via corresponding RF channel(s) 116. The combiner(s) 108 may generate, based on the RF signals, a combined output signal for transmission (e.g., via the antenna(s) 112). Communication channel(s) 120, separate from RF channel(s) 116 used for transmission of RF signals, may be set up between the transmitter(s) 104 and the combiner(s) 108. The communication channel(s) 120 and the RF channel(s) 116 may correspond to/use a same medium (e.g., same cable(s) and/or conductor(s)). As further described herein, the communication channel(s) 120 may be used for indicating, to the transmitter(s) 104, a connection status (e.g., of the combiner(s) 108, whether the combiner(s) 108 are operationally connected to the transmitter(s) 104), a total quantity of transmitter(s) 104, a total quantity of channels/output ports (e.g., of the transmitter(s) 104) that are supported by/connected to the combiner(s) 108, and/or the specific type(s) of combiner(s) 108 used in a combiner network. The indication may be in the form of a direct current (DC) voltage level (e.g., magnitude), a pulse wave, and/or any other type of indication. The communication channel(s) 120 may further be used for indicating, to the combiner(s) 108, a connection status (e.g., of the transmitter(s) 104, whether the transmitter(s) 104 are operationally connected to the combiner(s) 108).

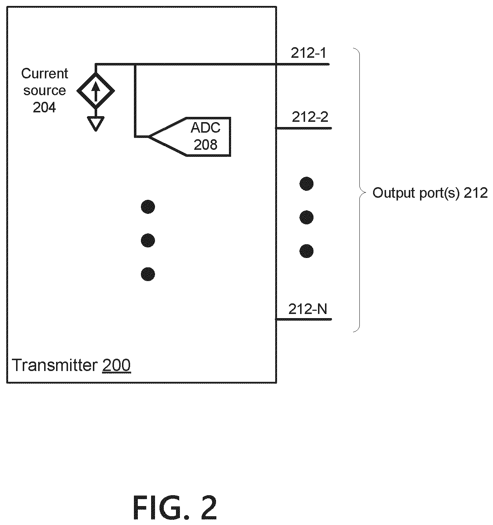

FIG. 2 shows an example configuration of output ports in a transmitter 200. The transmitter 200 may correspond to a transmitter 104 as shown in FIGS. 1A and 1B. The transmitter 200 may comprise one or more output ports 212 (e.g., output ports 212-1, 212-2...212-N). Each output port of the one or more output ports 212 may comprise/be associated with one or more of a current source and an analog to digital converter (ADC). Each output port of the one or more output ports 212 may be used for transmission of a corresponding RF signal. Each output port of the one or more output ports 212 may be connected a respective input port of a downstream combiner.

For example, as shown in FIG. 2, the output port 212-1 may be associated with a current source 204 and an ADC 208. The ADC 208 may detect an indication (e.g., a DC voltage level, a pulse wave, or any other form of indication) from a downstream component (e.g., a combiner of a combiner network) connected to the output port 212-1. The indication may correspond to an indication of a cumulative combining mode as indicated by the downstream component. The transmitter 200 may determine, based on the indication, a connection status (e.g., whether a combiner is connected to the output port 212-1), a total quantity of transmitter(s) supported by/connected to the combiner network, a total quantity of channels/output ports of the transmitter(s) that are supported by/connected to the combiner network, and/or type(s) of combiner(s) used in the combiner network.

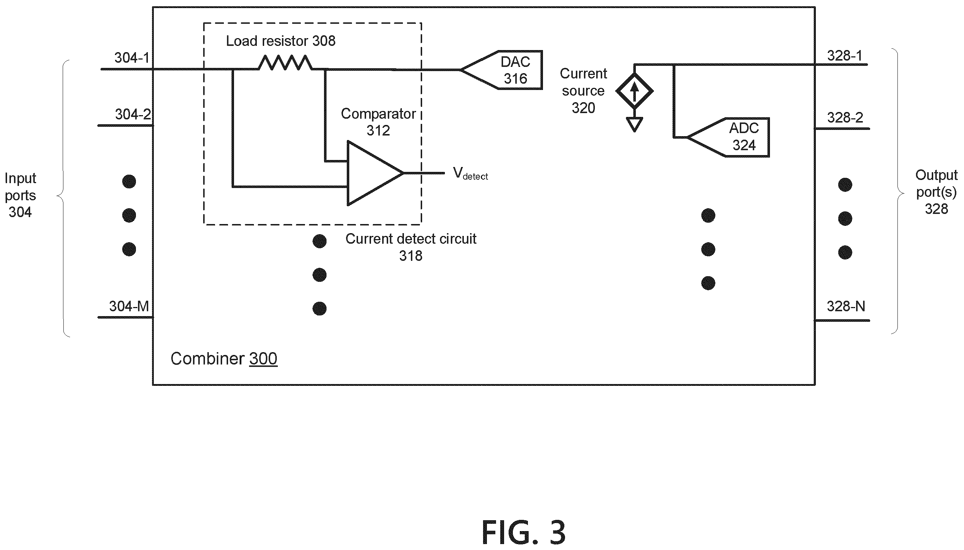

The ADC 208 of an output port 212-1 may detect an amplitude (e.g., a voltage level) of a pulse wave as generated by a downstream combiner (e.g., an active combiner) that may be connected to the output port 212-1. The transmitter 200 may determine a cumulative combining mode based on the amplitude of the pulse wave. In other examples, any other feature of a pulse wave (e.g., frequency, phase, etc.) may be used, by the downstream combiner, to indicate a cumulative combining mode. In other examples, any other form of indication (e.g., sine wave, square wave, triangle wave, any other analog or digital signal, etc.) may be used, by the downstream combiner, to indicate a cumulative combining mode. Additionally or alternatively, the ADC 208 may detect (e.g., based on the pulse wave, or any other form of indication) type(s) of the downstream combiner(s) used in the combiner network. ADCs associated with other output ports (e.g., output ports 212-2...212-N) may operate in a similar manner as the ADC 208 to detect the cumulative combining mode. An example operation of an active combiner, including generation of a signal indicating a cumulative combining mode, is described with respect to FIG. 3.

The transmitter 200 may adjust a power level of an output signal (e.g. an RF signal) via an output port (e.g., the output port 212-1, 212-2...212-N) based on the indication of the cumulative combining mode. For example, the power level may be proportional to the cumulative combining mode (e.g., a number of channels/signals being combined for transmission).

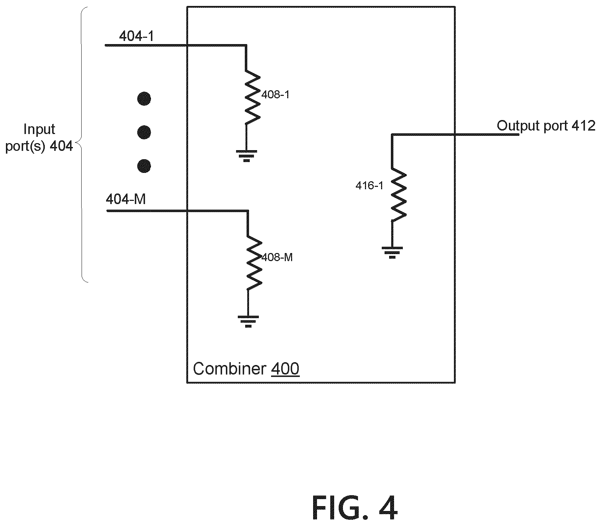

As another example, the ADC 208 may detect a DC voltage at a downstream combiner (e.g., a passive combiner) that may be connected to the output port 212-1. The transmitter 200 may determine a cumulative combining mode based on detecting the DC voltage and/or an amplitude of the DC voltage. An example operation of a passive combiner is described with respect to FIG. 4.

As another example, the ADC 208 may detect a DC voltage at a downstream antenna that may be connected to the output port 212-1. An amplitude of the DC voltage that may be detected at the downstream antenna may be different than an amplitude of the DC voltage that may be detected at a passive combiner connected to the output port 212.

The detection of the DC voltage, the pulse wave, or any other indication from the downstream combiner may also be considered as an indication of a successful connection of the output port 212-1 to an input port of a downstream combiner/combiner network. For example, based on determining that the connection is successful, the transmitter 200 may send RF signals via the output port 212-1.

Each output port 212 may further comprise other components (not shown) associated with transmission of a corresponding RF signal. For example, RF signals may be generated and transmitted via the one or more output ports 212 based on operations (e.g., mixing, amplification, etc.) as performed by the other components associated with the one or more output ports 212.

FIG. 3 shows an example combiner 300. The combiner 300 may correspond to a combiner 108 as shown in FIGS. 1A and 1B. The combiner 300 may be an active combiner. The combiner 300 may comprise a plurality of input ports 304 (e.g., input ports 304-1, 304-2... 304-M). Each port, of the plurality of input ports 304, may be used to input a corresponding RF signal from a corresponding output port of an upstream transmitter (e.g., the transmitter 200) or another combiner (e.g., similar to the combiner 300).

Each input port 304 may be associated with/connected to a corresponding load resistor, a corresponding comparator, and a corresponding digital to analog converter (DAC). For example, as shown in FIG. 3, the input port 304-1 may be connected to a load resistor 308, a comparator 312, and a DAC 316. The load resistor 308 and the comparator 312 may form a current detect circuit 318 that may be used to detect an output port of an upstream device (e.g., a transmitter, such as the transmitter 200) or another combiner (e.g., similar to the combiner 300) that may be connected to the input port 304-1. For example, when an output port of the upstream device is connected to the input port 304-1, a current source at the output port (e.g., the current source 204 of the transmitter 200) may generate a voltage across the load resistor 308. The voltage across the load resistor may be detected as a voltage V_{detect} at an output of the comparator 312. Detection of the voltage V_{detect} may be considered as an indication that an upstream device (e.g., a transmitter, another combiner, etc.) has been connected to the input port 304-1.

A digital to analog converter (DAC) 316 may generate, based on detection of the output port of the upstream device, an indication to signal (e.g., via the input port 304-1) a cumulative combining mode to the upstream device. The cumulative combining mode may be based on a combining mode of the combiner 300 and, if present, a cumulative combining mode as indicated by another combiner that may be connected to an output port (e.g., one of output ports 328). If no other combiner is connected to the output port (e.g., the output port is connected to an antenna), the cumulative combining mode may correspond to a combining mode of the combiner 300. The combining mode of the combiner 300 may correspond to a quantity of channels supported by the combiner, a quantity of input ports 304 of the combiner 300, a quantity of input signals being combined by the combiner 300, and/or a quantity of input ports 304 at which an output port of an upstream device (e.g., a transmitter or another combiner) is detected (e.g., by the current detect circuit 318). The combining mode of the combiner 300 may correspond to/may be based on a type of the combiner 300.

The signal to indicate the cumulative combining mode may be in the form of pulse wave. An amplitude (e.g., a voltage level/amplitude) of the pulse wave may correspond to/indicate the cumulative combining mode. In other examples, any other feature of a pulse wave (e.g., frequency, phase, etc.) may be used to indicate a cumulative combining mode. In other examples, any other form of indication (e.g., sine wave, square wave, triangle wave, any other analog or digital signal, etc.) may be used to indicate a cumulative combining mode. Load resistors, amplifiers, and DACs associated with other ports 304-2...304-M may operate in a manner similar to the load resistor 308, the comparator 312, and the DAC 316. The combiner 300 may indicate, via the input ports 304, any other type of information (e.g., different from the indication of the cumulative combining mode) in a similar manner. For example, the combiner 300 may indicate parameters such as gain (e.g., if the combiner 300 is capable of signal amplification), bandwidth of the combiner 300, frequency range of the combiner 300, connection mapping, etc.

The combiner 300 may further comprise one or more output ports 328 (e.g., output ports 328-1, 328-2... 328-N) that may be used to output a combined RF signal as generated based on RF signals at the input ports 304. In an example combiner comprising a plurality of output ports 328, the specific output port that is used to output the combined RF signal may be based on the combining mode of the combiner 300. A first output port 328-1 may be used to output a combined RF signal based on input via a first subset of the input ports 304. A second output port 328-2 may be used to output a combined RF signal based on input via a second subset of the input ports 304. A third output port 328-N may be used to output a combined RF signal based on input all of the input ports 304.

Similar to the transmitter 200, each of the output ports 328 of the combiner 300 may be associated with/connected to a corresponding current source and an ADC. For example, as shown in FIG. 3, the output port 328-1 may be connected to a current source 320 and an ADC 324. The current source 320 and the ADC 324 may operate in a manner that is similar, or substantially similar, to the current source 204 and the ADC 208 as described with reference to FIG. 2. The ADC 324 may detect an indication (e.g., a DC voltage level, a pulse wave, or any other form of indication) associated with another downstream combiner connected to the output port 328-1. The indication may correspond to an indication of a cumulative combining mode as indicated via an input port of the downstream combiner. The combiner 300 may determine, based on the indication, a connection status (e.g., whether another combiner is connected to the output port 328-1), the cumulative combining mode associated with the downstream combiner, and/or a type of the downstream combiner connected. The cumulative combining mode associated with the downstream combiner may be determined and indicated, by the downstream combiner, in a manner similar to that as described with respect to the DAC 316 and the input port 304-1 (e.g., if the downstream combiner is an active combiner). The cumulative combining mode of the downstream combiner may be determined and indicated, by the downstream combiner, in a manner such as described with respect to FIG. 4 (e.g., if the downstream combiner is a passive combiner).

Each input port 304 may further comprise other components (not shown) associated with reception and/or processing of a corresponding RF signal (e.g., from a transmitter such as the transmitter 200, or from another combiner similar to the combiner 300). Each output port 328 may further comprise other components (not shown) associated with processing and/or transmission of a corresponding RF signal (e.g., to another combiner similar to the combiner 300, or an antenna, etc.). The combiner 300 may additionally comprise other components (e.g., RF switches, Wilkinson combining structure(s), etc.) that are configured to generate a combined RF signal based on RF signals as input via the input ports 304.

FIG. 4 shows an example combiner 400. The combiner 400 may correspond to a combiner 108 as shown in FIGS. 1A and 1B. The combiner 400 may be an example passive combiner. The combiner 400 may comprise a plurality of input ports 404 (e.g., input ports 404-1... 404-M). Each port, of the plurality of input ports 404, may be used to input a corresponding RF signal from an output port of an upstream transmitter (such as the transmitter 200) or another combiner (e.g., similar to the combiner 300). The combiner 400 may comprise an output port 412. The output port 412 may be used to output a combined RF signal as generated based on RF signals at the input ports 404. In an example, the output port 412 may be in communication with and/or connected to an antenna for wireless transmission. Additionally or alternatively, the output port 412 may be in communication with and/or connected to a cable for wired transmission.

Each input port 404 may be associated with/connected to a corresponding load resistor 408. The load resistors 408 may be used for indicating, via the input ports 404, a cumulative combining mode. For example, when an output port of an upstream device (e.g., an active combiner such as the combiner 300, or a transmitter such as the transmitter 200) is connected to an input port 404-1, a current source at the output port (e.g., the current source 204 of the transmitter 200, the current source 320 of the combiner 300) may generate a voltage (e.g., a DC voltage) across the load resistor 408-1. The voltage across the load resistor 408-1 may be detected at the output port of the upstream device (e.g., by the ADC 208 or the ADC 324). The upstream device may determine the cumulative combining mode based on the detected voltage (e.g., a magnitude of the voltage).

In contrast to the combiner 300, the combiner 400 does not have any ADC or current source associated with its output port 412. Accordingly, the combiner 400 may be unable to determine the presence of, and/or a cumulative combining mode signaled by, any additional downstream combiners connected to the output port 412. As such, the combiner 400 may be a final stage of a combiner network. Since there are no additional downstream combiners, the cumulative combining mode as indicated by the combiner 400 may correspond to (e.g., may be the same as) a combining mode of the combiner 400 itself. The combining mode of the combiner may correspond to a quantity of input ports 404 of the combiner 400. The combining mode of the combiner 400 may correspond to/may be based on a type of the combiner 400.

The system 100 may also be capable of detecting an antenna. An input port of an antenna may present an open circuit or short circuit at DC. When an output port of an upstream device (e.g., an active combiner such as the combiner 300, or a transmitter such as the transmitter 200) is connected to an input port of the antenna, the output port may detect the open circuit or short circuit. Accordingly, the upstream device may be able to detect the antenna based on detection of an open circuit or a short circuit at the output port of the upstream device.

The system 100 may comprise a smart antenna that may indicate various parameters (e.g., in a manner similar to an active combiner). For example, the smart antenna may indicate gain, bandwidth, frequency range, and/or one or more other performance metrics (e.g., voltage standing wave ratio (VSWR)). The smart antenna may indicate the parameters using a wave (e.g., a pulse wave, sine wave, square wave, triangle wave, etc.). An amplitude (e.g., a voltage level/amplitude) and/or any other feature of the wave may correspond to/indicate one or more parameters.

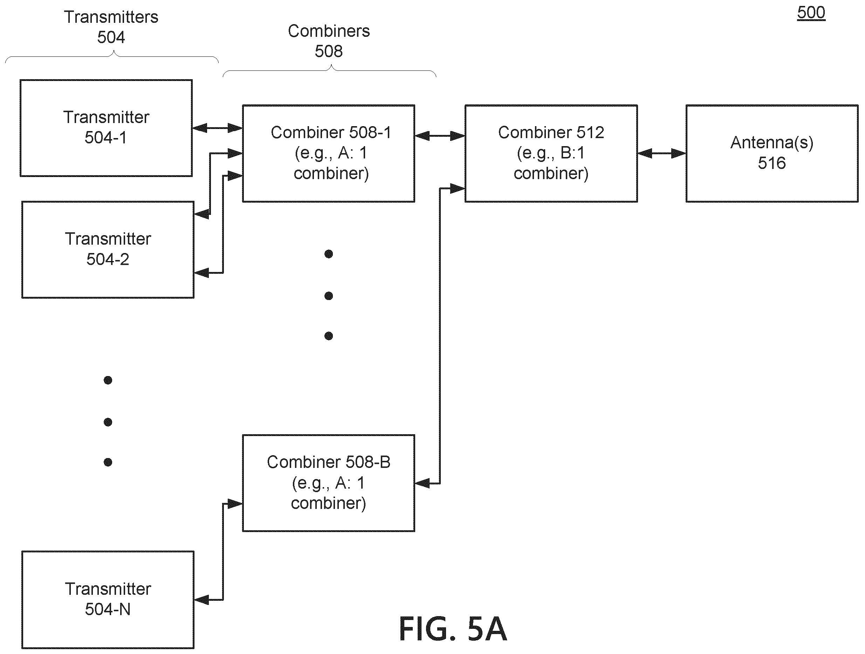

FIG. 5A shows an example system 500 comprising multiple transmitters. The example system 500 may use two signal combining stages to generate a combined output signal for transmission via antenna(s) 516. Input to the antenna(s) 516 may be in communication with and/or connected to an output port of a B:1 combiner 512 (e.g., a combiner comprising B input ports and 1 output port). Each of the B input ports of the combiner 512 may be in communication with and/or connected to an output port of a corresponding A:1 combiner 508 (e.g., a combiner comprising A input ports and 1 output port). Thus, the system 500 may comprise a first combining stage with B A:1 combiners 508, and a second combining stage with a single B:1 combiner 512.

The example system 500 may be capable of combining up to A×B signals for transmission via the antennas 516. As shown in FIG. 5A, the system 500 may comprise N transmitters 504 (transmitters 504-1...504-N), where N may be less than or equal to A×B. For example, each of the transmitters 504 may comprise one or more corresponding output ports. Accordingly, each of the transmitters 504 may generate corresponding one or more output signals for processing by the combiner network (e.g., comprising combiners 508 and the combiner 512).

The combiner 512 may determine a voltage level (e.g., a DC voltage level) at its output port. The combiner 512 may determine, based on the voltage level, that the combiner is connected to an antenna. Each of the input ports of the combiner 512 may correspondingly generate an indication of a first cumulative combining mode based on a combining mode of the combiner 512. The first cumulative combining mode may be equal to the combining mode of the combiner 512 since there are no additional combiners following the combiner 512. For example, the first cumulative combining mode may correspond to a B:1 combining mode. The indication of the first cumulative combining mode may be in the form of a DC voltage level (e.g., if the combiner 512 is a passive combiner), a pulse wave (e.g., if the combiner 512 is an active combiner), and/or any other form of indication. The indication of the first cumulative combining mode may be in the manner as described herein (e.g., with respect to FIGS. 3 and 4).

Each of the combiners 508 may detect, via respective output ports, the first cumulative combining mode as indicated by the combiner 512. Each of the combiners 508 may generate corresponding indications of a second cumulative combining mode of the combiners 508. The second cumulative combining mode may be based on the first cumulative combining mode (e.g., B:1 combining mode) as indicated by the combiner 512 and a combining mode of the combiners 508 (e.g., A:1 combining mode). Each of the input ports of the combiners 508 may correspondingly generate an indication of the second cumulative combining mode of the combiners 508. For example, the second cumulative combining mode may correspond to a A×B:1 combining mode. The indication of the cumulative combining mode may be in the form of a pulse wave and/or any other form of indication. The indication of the second cumulative combining mode as may be in the manner as described herein (e.g., with respect to FIG. 3).

The indication of the second cumulative combining mode may be used by the transmitters 504 for determining/adjusting output powers of output signals from the transmitters 504. For example, an output port of a transmitter 504-1 may comprise an ADC (e.g., as described with respect to FIG. 2) that may be used to detect the indication of the second cumulative combining mode (e.g., a pulse wave) as sent by the combiner 508-1. The transmitter 504-1 may determine, based that the indication of the second cumulative combining mode, that combiners 508 and the combiner 512 are cumulatively operating in an A×B:1 combining mode. The transmitter 504-1 may accordingly adjust a power level of an output signal as sent by the transmitter 504-1 to the combiner 508-1.

The specific combiners shown in the system 500 are exemplary, and in other examples, different types (e.g., with different quantities of input ports) and/or quantities of combiners may be used. For example, at least some of the combiners 508 and their associated transmitters 504 may be omitted from the system 500. Further, in other examples, any different quantity of combining stages (e.g., 1, 3, 4, etc.) may be used to combine a plurality of signals for transmission.

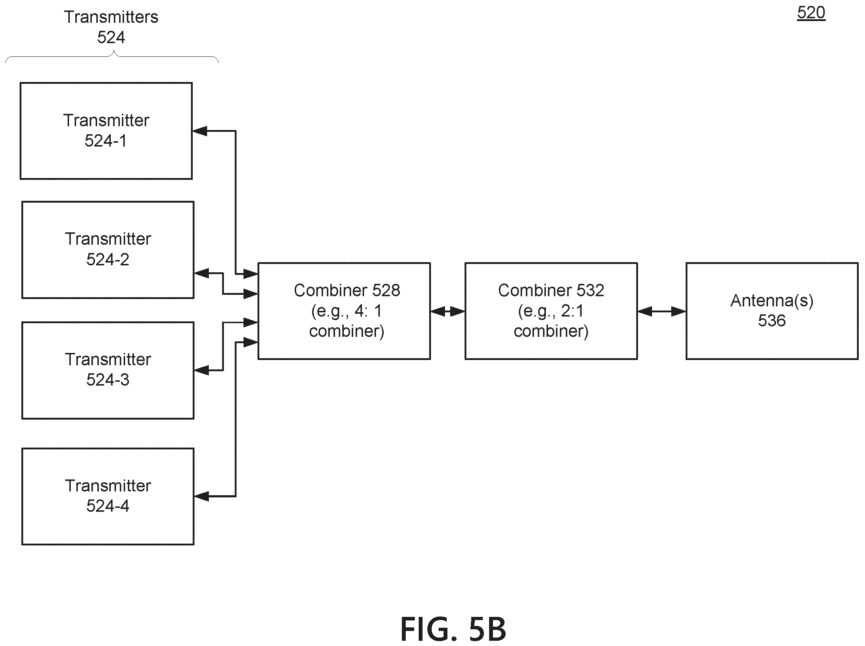

FIG. 5B shows an example system 520 comprising multiple transmitters. The example system 520 may use two signal combining stages to generate a combined output signal for transmission via antenna(s) 536. A first combining stage may comprise a 4:1 combiner 528 and a second combining stage may comprise a 2:1 combiner 532.

The combiner 528 may detect, via an output port of the combiner 528, a first cumulative combining mode as indicated via an input port of the combiner 532. For example, the combiner 532 may be a passive combiner, and the combiner 528 may detect, via the output port, an indication of the first cumulative combining mode as a DC voltage level (e.g., as described with respect to FIGS. 3 and 4) at the input port of the combiner 532. The combiner 528 may detect, based on the DC voltage level, that the first cumulative combining mode corresponds to a 2:1 combining mode. The combiner 528 may detect, based on the DC voltage level, that the combiner 532 is a 2:1 combiner.

The combiner 528 may generate an indication of a second cumulative combining mode. The second cumulative combining mode may be based on the first cumulative combining mode (e.g., 2:1 combining mode) as indicated by the combiner 532 and a combining mode of the combiner 528 (e.g., 4:1 combining mode). Each of the input ports of the combiner 528 may correspondingly generate an indication of the second cumulative combining mode of the combiner 528. For example, the second cumulative combining mode may correspond to an 8:1 combining mode. The indication of the second cumulative combining mode may be in the form of a pulse wave and/or any other form of indication.

The indication of the second cumulative combining mode may be used by the transmitters 524 (e.g., transmitters 524-1, 524-2... 524-4) for determining/adjusting output powers of output signals from the transmitters 524. For example, an output port of a transmitter 524-1 may comprise an ADC (e.g., as described with respect to FIG. 2) that may be used to detect the indication of the second cumulative combining mode (e.g., a pulse wave) as sent by the combiner 528. The transmitter 524-1 may determine, based that the indication of the second cumulative combining mode, that combiners 528 and the combiner 532 are cumulatively operating in an 8:1 combining mode. The transmitter 524-1 may accordingly adjust a power level of an output signal as sent by the transmitter 524-1 to the combiner 528.

While not shown in FIG. 5B, the system 520 may comprise a second 4:1 combiner whose output port may be connected to a second input port of the combiner 532. The input ports of the second 4:1 combiner may be connected to four other transmitters that may operate in a manner similar to the transmitters 524. The second 4:1 combiner may similarly indicate an 8:1 combining mode to the four other transmitters.

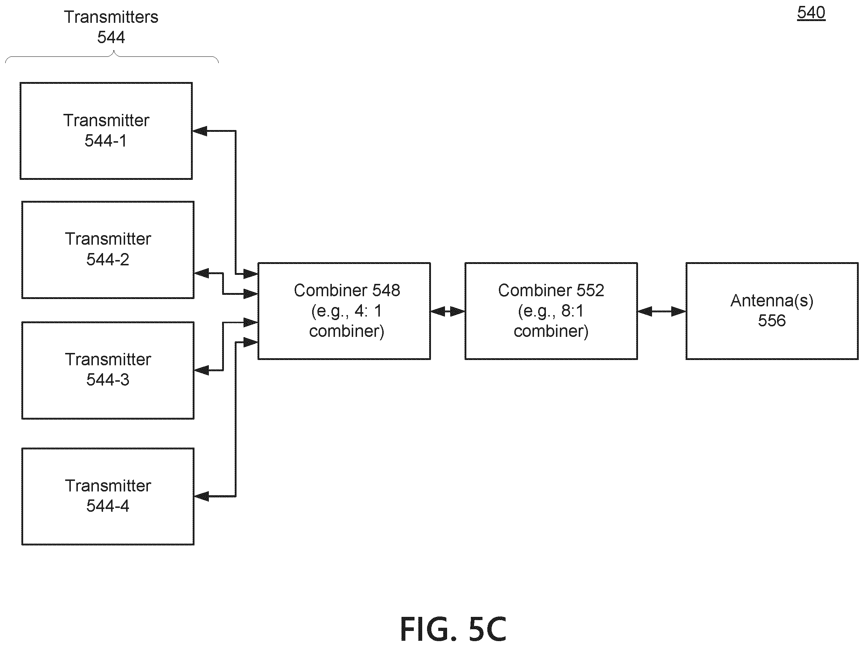

FIG. 5C shows an example system 540 comprising multiple transmitters. The example system 540 may use two signal combining stages to generate a combined output signal for transmission via antenna(s) 556. A first combining stage may comprise a 4:1 combiner 548 and a second combining stage may comprise an 8:1 combiner 552.

The combiner 552 may generate an indication of a first cumulative combining mode. The first cumulative combining mode may be the combining mode (e.g., 8:1 combining mode) of the combiner 552 (e.g., since an output port of the combiner 552 is connected to an antenna, and not to another downstream combiner). Each of the input ports of the combiner 552 may correspondingly generate an indication of the first cumulative combining mode of the combiner 552. The indication of the first cumulative combining mode may be in the form of a pulse wave and/or any other form of indication.

The combiner 548 may detect the first cumulative combining mode via an output port of the combiner 548. The combiner 548 may generate an indication of a second cumulative combining mode. The second cumulative combining mode may be based on the first cumulative combining mode (e.g., 8:1 combining mode) as indicated by the combiner 552 and a combining mode of the combiner 548 (e.g., 4:1 combining mode). Each of the input ports of the combiner 548 may correspondingly generate an indication of the second cumulative combining mode of the combiner 548. For example, the second cumulative combining mode may correspond to a 32:1 combining mode. The indication of the cumulative combining mode may be in the form of a pulse wave and/or any other form of indication.

The indication of the second cumulative combining mode may be used by the transmitters 544 (e.g., transmitters 544-1, 544-2... 544-4) for determining/adjusting output powers of output signals from the transmitters 544. For example, an output port of a transmitter 544-1 may comprise an ADC (e.g., as described with respect to FIG. 2) that may be used to detect the indication of the second cumulative combining mode (e.g., a pulse wave) as sent by the combiner 548. The transmitter 544-1 may determine, based that the indication of the second cumulative combining mode, that combiners 548 and the combiner 552 are cumulatively operating in a 32:1 combining mode. The transmitter 544-1 may accordingly adjust a power level of an output signal as sent by the transmitter 544-1 to the combiner 548.

While not shown in FIG. 5C, the system 540 may comprise seven more 4:1 combiners whose output ports may be respectively connected to the seven other input ports of the combiner 552. The input ports of the other 4:1 combiners may be connected to other transmitters that may operate in a manner similar to the transmitters 544. The other 4:1 combiners may similarly indicate a 32:1 combining mode to their respective transmitters.

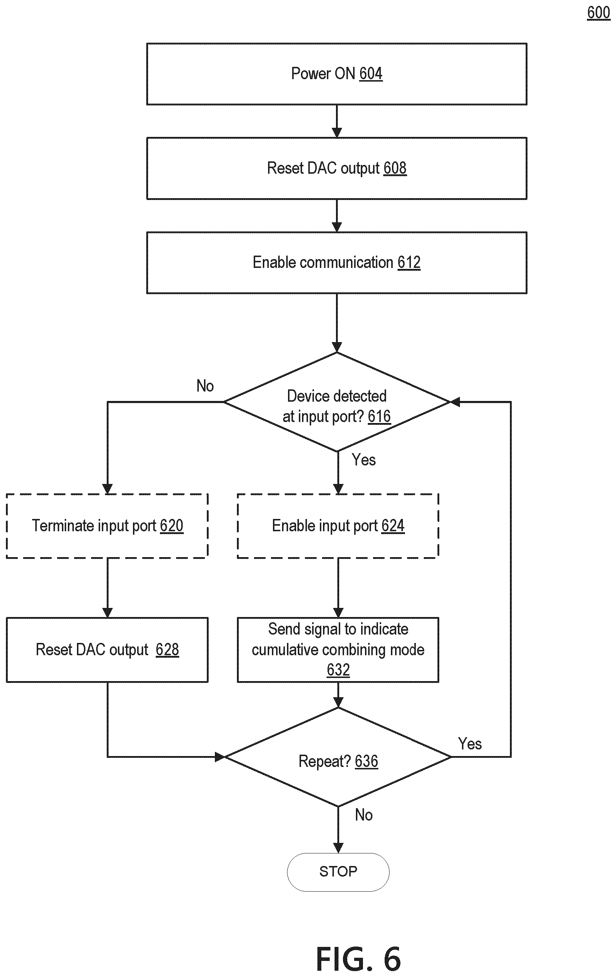

FIG. 6 shows an example method 600 of operation of a combiner. The combiner may correspond to an active combiner (e.g., combiner 300 as described with respect to FIG. 3). The example method 600 may correspond to upstream communication, as performed via an input port of a combiner, to indicate a cumulative combining mode to an upstream device (e.g., another combiner, or a transmitter, etc.).

At step 604, the combiner may be powered on. Powering on the combiner may correspond to activating a power supply associated with a combiner network comprising the combiner. At step 608, the combiner may reset an output of a DAC associated with an input port of the combiner. The combiner may reset output of DACs associated with each of the input ports of the combiner. Resetting an output of a DAC may comprise setting a voltage level of the DAC to indicate that the combiner is in an unused state. Resetting an output of a DAC may comprise providing any other type of indication, via the DAC, to indicate that the combiner is in an unused state. At step 612, the combiner may enable/activate its circuitry for upstream communication via the input ports. For example, the combiner may enable/activate its circuitry for cascaded communication with an upstream device (e.g., another combiner, or a transmitter) and/or a downstream device (e.g., another combiner, or an antenna).

At step 616, the combiner may determine whether a device (e.g., an upstream device such as another combiner, or a transmitter) is detected at an input port of the combiner. For example, the combiner may determine, using a current detect circuit associated with the input port (e.g., as described with respect to FIG. 3), whether a device is connected to the input port. The current detect circuit may determine whether a current source of an output port (e.g., of an upstream device such as another combiner, or a transmitter) is connected to the input port.

At step 624, and based on detection of a device at the input port, the combiner may optionally enable (e.g., un-terminate/activate/open) the input port (e.g., if not already enabled). For example, the combiner may configure the input port for upstream communication. At step 632, the combiner (e.g., the DAC associated with the input port of the combiner) may send, via the input port, an indication of a cumulative combining mode associated with the combiner. The cumulative combining mode may be determined/indicated as described with respect to FIGS. 3 and 5. The combiner may indicate, via the input port, any other type of information (e.g., different from the indication of the cumulative combining mode) in a similar manner (e.g., via the DAC).

At step 620, and based on no device being detected at the input port, the combiner may optionally terminate the input port (e.g., using a 50-ohm termination). Terminating the input port may minimize the losses associated with other input ports of the combiner (e.g., if being used). At step 628, the combiner may reset an output of the DAC associated with the input port based on no device being detected at the input port.

One or more of the steps 616, 620, 624, 628, and/or 632 may be repeated while the combiner is powered on/operational. For example, at step 636, the combiner may determine whether to repeat the steps 616, 620, 624, 628, and/or 632. The combiner may use a counter and/or a timer to determine whether to repeat the steps. For example, a counter may track a number of attempts to detect a device at the input port. Additionally, or alternatively, a timer may track a time period for which the combiner may attempt to detect a device at the input port. If a device is not detected after a threshold number of attempts and/or within a threshold period of time, the combiner may end operation and power down (e.g., to conserve power). Determining whether to repeat the steps 616, 620, 624, 628, and/or 632 may be based on any other condition (e.g., based on determining that the device remains powered on).

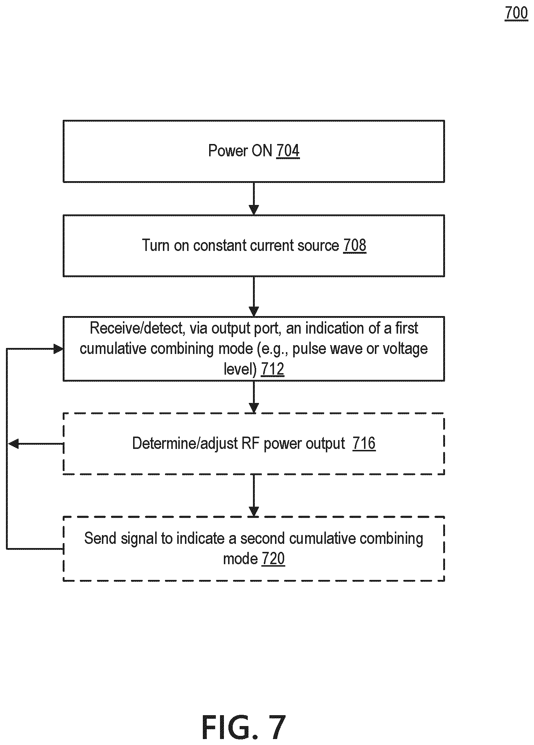

FIG. 7 shows an example method 700 for detection and processing of an indication of a cumulative combining mode. The example method 700 may be performed by a transmitter (e.g., the transmitter 200) and/or a combiner (e.g., the combiner 300). The example method 700 may be used to receive and/or process communication, as received from a downstream device (e.g., a combiner), indicating a cumulative combining mode of the downstream device.

At step 704, a device (e.g., a transmitter or a combiner) may be powered on. Powering on the device may correspond to activating a power supply associated with the device. At step 708, the device may activate (e.g., turn on) a constant current source associated with an output port of the device. The constant current source may be used to indicate, to a downstream device, that the output port of the device is connected to an input port of the downstream device.

At step 712, the device may detect, via the output port, an indication of a first cumulative combining mode. The indication of the first cumulative combining mode may be generated and/or transmitted by the input port of the downstream device (e.g., another combiner). The indication of the first cumulative combining mode may correspond to a pulse wave, a DC voltage level, and/or any other indication. The indication of the first cumulative combining mode may correspond to a pulse wave, for example, if the downstream device is an active combiner. The indication of the first cumulative combining mode may correspond to a DC voltage level, for example, if the downstream device is a passive combiner. The first cumulative combining mode may be indicated, via the input port of the downstream device, as described with respect to FIGS. 3, 4, and/or 5.

At step 716, and if the device is a transmitter (e.g., the transmitter 200), the device may determine/adjust a power level of an output signal for transmission via the output port. The device may determine/adjust the power level of the output signal based on the indication of the first cumulative combining mode (e.g., as received at step 712). The device may determine/adjust the power level of the output signal to be proportional to the cumulative combining mode.

At step 720, and if the device is a combiner (e.g., the combiner 300), the device may send an indication of a second cumulative combining mode. The device may determine the second cumulative combining mode based on the first cumulative combining mode and a combining mode of the device. The device may send the indication of the second cumulative combining mode via an input port of the device. The device may send the indication of the second cumulative combining mode to an upstream device (e.g., another combiner, or a transmitter).

The device may continually update its determination of the first cumulative combining mode based on receiving/detecting an indication via the output port (e.g., at step 712). If the device is a transmitter, any change in the first cumulative combining mode may be reflecting as a change in the power level of the output signal via the output port. If the device is a combiner, any change in the first cumulative combining mode may be reflecting as a change in indication of the second cumulative combining mode.

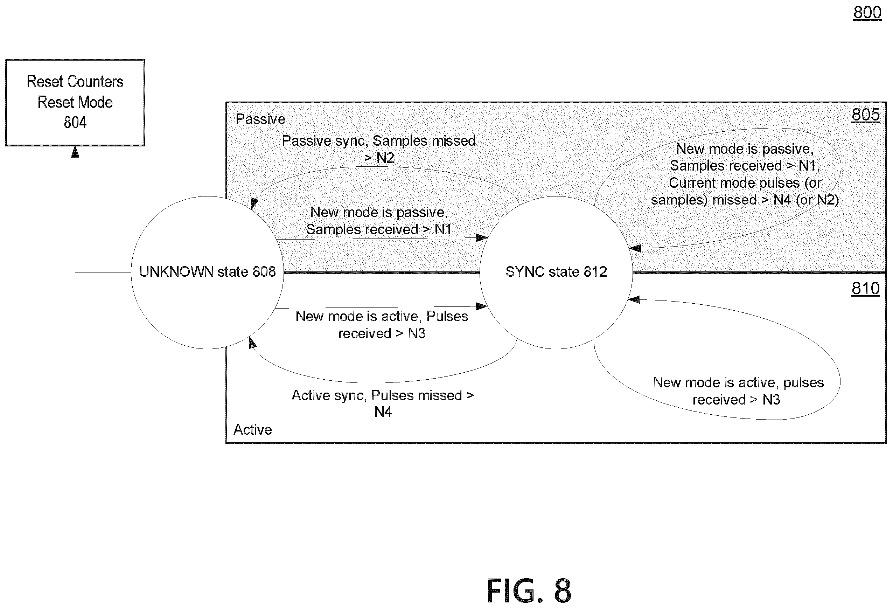

FIG. 8 shows an example state diagram 800 of a device that is connected to a downstream combiner. The device may be connected to the downstream combiner via an output port of the device. Block 805 may apply for passive operating modes (e.g., when the downstream combiner is a passive combiner, open/short circuit at the output port, etc.). Block 810 may apply for active operating modes (e.g., when the downstream combiner is an active combiner). The device may be an upstream combiner (e.g., an active combiner) or a transmitter.

The device may be associated with counters that may track a quantity of pulses (e.g., of a pulse wave) received, a quantity of pulses missed, a quantity of samples received, and/or a quantity of samples missed. An unknown state 808 may be a state at which the device does not have a determination of a cumulative combining mode at the output port. The device may reset its counters (e.g., counters associated with pulses received and/or samples received) when entering the unknown state 808 (e.g., at step 804). In the unknown state 808, the device may reset any prior determination of a cumulative combining mode. For example, the device may determine that any prior determination of a cumulative combining mode is no longer applicable.

A sync state 812 may be a state at which the device has determined a valid operating mode (e.g., cumulative combining mode, an open circuit, a short circuit, etc.) indicated at the output port. On transition to the sync state 812 (e.g., on transition to a new sync state), the device may reset its counters. If the device is a transmitter, the device may adjust its transmission power, via the output port, based on the determined cumulative combining mode. If the device is a combiner, the device may adjust its signal indicating a second cumulative combining mode (e.g., to an upstream device) based on the determined cumulative mode at the output port and a combining mode of the device (e.g., as described with respect to FIG. 3).

If the downstream combiner is a passive combiner, the device may transition from the unknown state 808 to the sync state 812 based on receiving more than a threshold quantity of samples (e.g., at a specific voltage level associated with the downstream combiner). For example, the device may sample the voltage across a load resistor of the downstream combiner (e.g., at a sampling rate) and determine whether the number of samples (e.g., consecutive samples) at a voltage level (e.g., across the load resistor) is greater than a first threshold quantity (e.g., N1). Based on the number of samples at the voltage level exceeding the first threshold N1, the device may enter the sync state 812. The device may further determine a cumulative combining mode, as indicated by the downstream combiner, based on the voltage level. The device may similarly detect an open circuit or a short circuit based on detection of a corresponding voltage level associated with an open circuit or a short circuit. The device may remain in the sync state 812 unless a number of samples (e.g., consecutive samples) missed at that voltage level satisfies or exceeds a second threshold quantity (e.g., N2). For example, if the device, after entering the sync mode 812 based on the number of samples (e.g., at the voltage level) exceeding N1, determines that the device has missed at least N2 consecutive samples (e.g., at the voltage level), the device may re-enter the unknown state 808. Using consecutive missed samples for determining whether to re-enter the unknown state 808 may advantageously prevent the device from abruptly switching to the unknown state 808 in response to an unreliable connection.

**If** the downstream combiner is a passive combiner, the sync state 812 may correspond to a detection of a passive combiner or a combining mode (e.g., a 2:1 combining mode, or any other combining mode of a passive downstream combiner). In some scenarios, the device may detect samples at other voltage levels that are not associated with a downstream passive combiner. For example, based on detection of a corresponding voltage level, the sync state 812 may correspond to detection of a 1:2 mode (e.g., detection of a power splitter operating in a 1:2 mode), detection of a short circuit at an output port, and/or a detection of an open circuit at the output port.

If the downstream combiner is an active combiner, the device may transition from the unknown state 808 to the sync state 812 based on receiving more than threshold quantity of pulses (e.g., at a specific voltage level associated with the cumulative combining mode of the downstream combiner). For example, the device may determine whether the number of pulses (e.g., consecutive pulses) at a voltage level (e.g., associated with the cumulative combining mode of the downstream combiner) is greater than a third threshold quantity (e.g., N3). Based on the number of pulses at the voltage level exceeding the third threshold N3, the device may enter the sync state 812. The device may further determine a cumulative combining mode, as indicated by the downstream combiner, based on the voltage level. The sync state 812 may correspond to a detection of an active combiner and/or an associated cumulative combining mode (e.g., a 64:1 combining mode, a 32:1 combining mode, a 16:1 combining mode, an 8:1 combining mode, a 4:1 combining mode, and/or any other cumulative combining mode indicated by the active downstream combiner).

The device may remain in the sync state 812 unless a number of pulses (e.g., consecutive pulses) missed exceeds a fourth threshold quantity (e.g., N4). For example, if the device, after entering the sync mode 812 based on the number of pulses exceeding N3, determines that the device has missed at least N4 consecutive pulses, the device may re-enter the unknown state 808. The device may determine that a pulse has been missed, for example, if the device does not receive another pulse within a timeout window following a last received pulse. Using consecutive missed pulses for determining whether to re-enter the unknown state 808 may advantageously prevent the device from abruptly switching to the unknown state 808 in response to an unreliable connection.

The device may remain in the sync state 812 but may determine a different cumulative combining mode of the downstream combiner, for example, based on receiving pulses at a different voltage level and based on the number of received pulses exceeding the third threshold N3. The device may reset its counters if a different cumulative combining mode of the downstream combiner is determined.

The device may use a table (e.g., stored in a memory associated with the device) to determine an operating mode (e.g., a cumulative combining mode, an open circuit, a short circuit, etc.) based on voltage levels of received pulses and/or samples. The table may map voltage levels to corresponding operating modes. The device may transition to or remain in the unknown state 808, for example, based on detection of samples or pulses at an unrecognized voltage level (e.g., not assigned/mapped to a specific mode/operating state).

The values of the thresholds N1 and N2 may be same or may be different. The values of the thresholds N3 and N4 may be same or may be different. In at least some arrangements, N1 may be equal to N3 and/or N2 may be equal to N4.

In at least some instances, the device may remain in the sync state 812 (e.g., re-enter the sync state 812 with a new mode) even if the device has missed at least N2 samples. For example, the device may re-enter the sync state 812, with a new mode, even if the device has missed at least N2 samples (e.g., at a voltage level) from a passive downstream combiner (e.g., a 2:1 combiner) based on the device receiving at least N1 samples (e.g., at a second voltage level). The second voltage level may correspond to an open circuit . For example, this scenario may occur if the passive downstream combiner is removed (e.g., open circuit at the output port). The second voltage level may correspond to a different cumulative combining mode. For example, this scenario may occur if an RF switch changes a path (e.g., instantaneously), from the output port of the device, to a second passive downstream combiner or a power splitter (e.g., operating in a 1:2 mode). The device may further determine a new cumulative combining mode, as indicated by the second passive downstream combiner/power splitter, based on the second voltage level and without transitioning to the unknown state 808.

In at least some instances, the device may remain in the sync state 812 (e.g., re-enter the sync state 812 with a new mode) even if the device has missed at least N4 pulses. For example, the device may remain in the sync state 812 even if the device has missed at least N4 pulses based on the device receiving at least N1 samples (e.g., associated with a passive operating mode). The device may further determine a new cumulative combining mode based on a voltage level associated with the N1 samples as received and without transitioning to the unknown state 808.

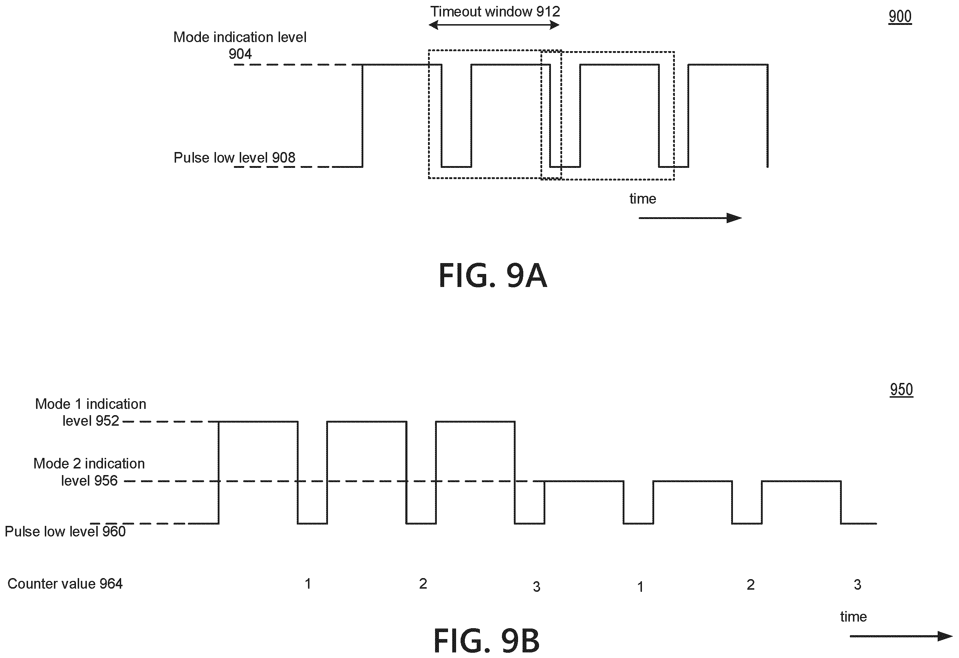

FIGS. 9A and 9B shows example indications of a cumulative combining mode to an upstream device. The example indications may be in the form of pulse waves generated by an active downstream combiner (e.g., at a DAC associated with an input port of the downstream combiner).

FIG. 9A shows a pulse wave 900 associated with a mode indication level 904. The mode indication level 904 may be an amplitude/voltage level of the pulse wave 900 that may be used to indicate a cumulative combining mode to an upstream device. For example, the upstream device may determine a cumulative combining mode based on the mode indication level 904 associated with the pulse wave 900. The pulse wave 900 may switch between the mode indication level 904 and the pulse low level 908. As described with respect to FIG. 8, the upstream device may determine the cumulative combining mode based on a quantity of pulses exceeding a threshold value.

FIG. 9A also shows a timeout window 912 which may be used to detect missed pulses (e.g., at the upstream device). The timeout window 912 may be initiated with a last sample associated with a complete pulse. If no pulse is detected within the timeout window 912, the upstream device may determine that a pulse has been missed, and may appropriately increment a counter used for tracking a quantity of missed pulses.

FIG. 9B shows an example pulse wave 950 showing switching of an indication of a cumulative combining mode. Mode 1 indication level 952 may correspond to a voltage level associated with a first cumulative combining mode. Mode 2 indication level 956 may correspond to a voltage level associated with a second cumulative combining mode. The downstream device may change an amplitude of the pulse wave 950 from the mode 1 indication level 952 to the mode 2 indication level 956 to indicate a change from the first cumulative combining mode to the second cumulative combining mode. The pulse wave 950 may switch between a mode indication level and a pulse low level 960.

FIG. 9B also shows a counter used to track a quantity of received pulses at the upstream device. As shown in FIG. 9B, a counter value 964, associated with the counter, may be reset based on determining a change in an amplitude (e.g., a mode indication level) associated with the pulse wave 950.

An upstream device may determine the first cumulative combining mode based on a quantity of received pulses, at the mode 1 indication level 952, exceeding a threshold value (e.g., as described with respect to FIG. 8). Further, the upstream device may determine a change in a cumulative combining mode (e.g., from the first cumulative combining mode to the second cumulative combining mode) based on a quantity of pulses, at the mode 2 indication level 956, exceeding the threshold value.

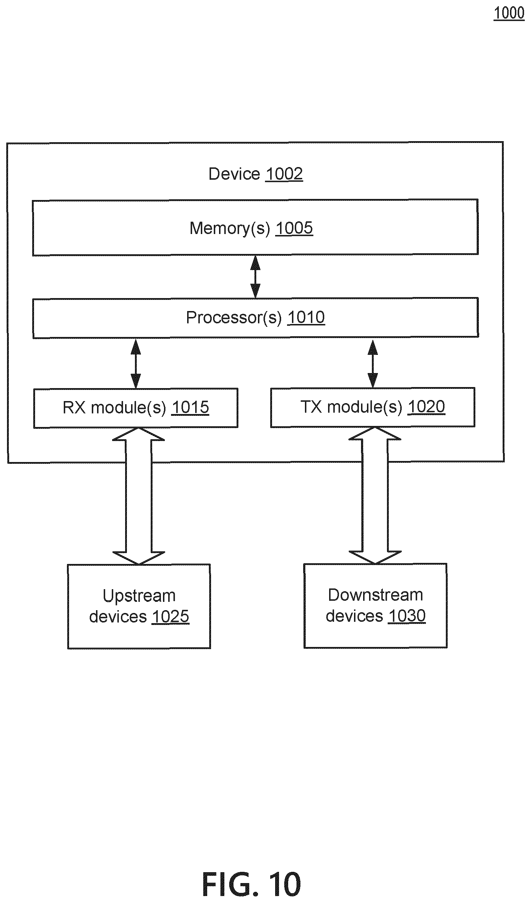

FIG. 10 shows an example system 1000 in accordance with one or more examples as described herein. A device 1002 in the system 1000 may correspond to a transmitter or a combiner as described herein. The device 1002 may comprise one or more of processor(s) 1010, transmit (TX) module 1015, receive (RX) module(s) 1020, and/or memory 1005. One or more data buses may interconnect the processor(s) 1010, the TX module(s) 1020, RX module(s) 1015, and/or the memory 1005. The device 105 may be implemented using one or more integrated circuits (ICs), software, or a combination thereof, configured to operate as described herein. The memory 1005 may comprise any memory such as a random-access memory (RAM), a read-only memory (ROM), a flash memory, or any other electronically readable memory, or the like. The processor(s) 1010, the TX module(s) 1020, RX module(s) 1015, and/or other component/modules of the device 1002 may be configured to execute machine readable instructions stored in the memory 1005 to perform the various operations described herein. The TX module(s) 1020 and/or RX module(s) 1015 may comprise one or more of mixers, amplifiers, drivers, etc., for transmission, reception, and/or processing of signals. The TX module(s) 1020 and/or RX module(s) 1015 may comprise ADCs, DACs, load resistors, current sources, device detect circuits, etc., configured to perform the various operations as described herein for indicating and/or determining a cumulative combining mode.

The device 1002 may be connected to one or more devices. The device 1002 may be connected to one or more downstream devices 1030 (e.g., combiners and/or antennas). For example, the RX module(s) 1020 may be associated with one or more output ports that are connected to an input port of a downstream combiner. The device 1002 may be connected to one or more upstream devices 1025 (e.g., transmitters and/or combiners). For example, the TX module(s) 1015 may be associated with one or more input ports that are connected to an output port of an upstream combiner or a transmitter.

Signals (e.g., audio signals, or any other type of signals) transmitted from and/or received by the device 1002 may comprise analog signals and/or digital signals. The processor(s) 1010 may implement functionalities associated with one or more layers of an open systems interconnection (OSI) model, representing the operations of the device 1002, in accordance with one or more communication protocols for transmission, reception, and/or processing of signals.

Communications involving the system 1000 may be via any proprietary and/or non-proprietary communication standards. For example, the TX module(s) 1020/RX module(s) 1015 may be configured to send/receive signals that are processed using one or more communication protocols corresponding to one or more layers in the OSI model (e.g., Bluetooth protocol(s), Institution of Electrical and Electronics Engineers (IEEE) 802.11 Wi-Fi protocol(s), 3^{rd} Generation Partnership Project (3GPP) cellular protocol(s), local area network (LAN) protocol(s), hypertext transfer protocols (HTTP), side-channel communication protocol(s), and/or any other communication protocol(s)).

In an example, the communication involving the system 1000 may be via wireless channels that are designated as industrial, scientific, and medical (ISM) bands defined by the International Telecommunication Union (ITU) Radio Regulations (e.g., a 2.4 GHz-2.5 GHz band, a 5.75 GHz-5.875 GHz band, a 24 GHz-24.25 GHz band, and/or a 61 GHz-61.5 GHz band, etc.). Additionally, or alternatively, the communication between the devices in the communication system 100 may be via (e.g., one or more channels within) a very high frequency (VHF) band (e.g., 30 MHz-300 MHz band) and/or via (e.g., one or more channels within) an ultra-high frequency (UHF) band (e.g., 300 MHz-3 GHz).

One or more aspects of the disclosure may be embodied in computer-usable data or computer-executable instructions, such as in one or more program modules, executed by one or more computers or other devices to perform the operations described herein. Generally, program modules include routines, programs, objects, components, data structures, and the like that perform particular tasks or implement particular abstract data types when executed by one or more processors in a computer or other data processing device. The computer-executable instructions may be stored as computer-readable instructions on a computer-readable medium such as a hard disk, optical disk, removable storage media, solid-state memory, RAM, and the like. The functionality of the program modules may be combined or distributed as desired in various embodiments. In addition, the functionality may be embodied in whole or in part in firmware or hardware equivalents, such as integrated circuits, application-specific integrated circuits (ASICs), field programmable gate arrays (FPGA), and the like. Particular data structures may be used to more effectively implement one or more aspects of the disclosure, and such data structures are contemplated to be within the scope of computer executable instructions and computer-usable data described herein.

Various aspects described herein may be embodied as a method, an apparatus, or as one or more computer-readable media storing computer-executable instructions. Accordingly, those aspects may take the form of an entirely hardware embodiment, an entirely software embodiment, an entirely firmware embodiment, or an embodiment combining software, hardware, and firmware aspects in any combination. In addition, various signals representing data or events as described herein may be transferred between a source and a destination in the form of light or electromagnetic waves traveling through signal-conducting media such as metal wires, optical fibers, or wireless transmission media (e.g., air or space). In general, the one or more computer-readable media may be and/or include one or more non-transitory computer-readable media.

As described herein, the various methods and acts may be operative across one or more computing servers and one or more networks. The functionality may be distributed in any manner, or may be located in a single computing device (e.g., a server, a client computer, and the like). For example, in alternative embodiments, one or more of the computing platforms discussed above may be combined into a single computing platform, and the various functions of each computing platform may be performed by the single computing platform. In such arrangements, any and/or all of the above-discussed communications between computing platforms may correspond to data being accessed, moved, modified, updated, and/or otherwise used by the single computing platform. Additionally or alternatively, one or more of the computing platforms discussed above may be implemented in one or more virtual machines that are provided by one or more physical computing devices. In such arrangements, the various functions of each computing platform may be performed by the one or more virtual machines, and any and/or all of the above-discussed communications between computing platforms may correspond to data being accessed, moved, modified, updated, and/or otherwise used by the one or more virtual machines.

Aspects of the disclosure have been described in terms of illustrative embodiments thereof. Numerous other embodiments, modifications, and variations within the scope and spirit of the appended claims will occur to persons of ordinary skill in the art from a review of this disclosure. For example, one or more of the steps depicted in the illustrative figures may be performed in other than the recited order, and one or more depicted steps may be optional in accordance with aspects of the disclosure.

## Claims

1. A method comprising:
detecting, by a combiner comprising a plurality of input ports and an output port, a voltage level at the output port, wherein the combiner is configured to generate, based on audio signals received via the plurality of input ports, a combined audio signal for transmission via the output port;
determining, based on the voltage level, a downstream combining mode; and
transmitting, via an input port of the plurality of input ports, an indication of a cumulative combining mode, wherein the cumulative combining mode is based on the downstream combining mode and a combining mode of the combiner.

2. The method of claim 1, wherein the transmitting the indication of the cumulative combining mode comprises transmitting a pulse wave with an amplitude indicating the cumulative combining mode.

3. The method of claim 1 or claim 2, further comprising:
receiving, via one or more of the plurality of input ports, radio frequency (RF) signals associated with the audio signals; and
transmitting, via the output port, a combined RF signal generated based on the RF signals, wherein the combined RF signal corresponds to the combined audio signal.

4. The method of any one of claims 1 to 3, wherein the transmitting the indication of the cumulative combining mode is based on detection of a device at the input port.

5. The method of claim 4, wherein the device comprises a transmitter or a second combiner.

6. The method of any one of claims 1 to 5, wherein the downstream combining mode is a second cumulative combining mode associated with a second combiner in communication with the output port.

7. The method of any one of claims 1 to 6, further comprising:
based on detecting an absence of a device being connected to a second input port of the plurality of input port, terminating the second input port.

8. A method comprising:
determining, by a transmitter and based on a voltage level at an output port of the transmitter, a cumulative combining mode, wherein the cumulative combining mode is based on a combining mode of a combiner in communication with the output port of the transmitter and a downstream combining mode associated with one or more combiners in communication with an output port of the combiner;
determining, based on the cumulative combining mode, a power level for a radio frequency (RF) signal; and
transmitting, based on the determined power level, the RF signal via the output port.

9. The method of claim 8, wherein the power level is proportional to a number of channels associated with the cumulative combining mode.

10. The method of any one of claims 1 to 9, wherein:
when dependent on claim 1, the detecting the voltage level comprises detecting at least a threshold quantity of pulses of a pulse wave, wherein the voltage level is equal to an amplitude of the pulse wave; or
when dependent on claim 8, the determining the cumulative combining mode comprises detecting at least a threshold quantity of pulses of the pulse wave.

11. The method of any one of claims 1 to 10, wherein the voltage level corresponds to an amplitude of a pulse wave as detected at the output port.

12. The method of any one of claims 1 to 11, wherein the voltage level is associated with a voltage across load resistor of a downstream combiner that is connected to the output port.

13. A device comprising:
one or more processors; and
memory storing instructions that, when executed by the one or more processors, cause the device to perform the method of any one of claims 1 to 12.

14. A system comprising:
a combiner configured to perform the method of any one of claims 1 to 8, or the method of any one of claims 10 to 12 when dependent on claim 1; and
a transmitter configured to perform the method of any one of claims 9 to 12 when dependent on claim 8.

15. A computer-readable medium storing instructions that, when executed, cause performance of the method of any one of claims 1 to 12.
